Europäisches Patentamt

European Patent Office

Office européen des brevets

(11) Publication number: **0 219 626**
**A2**

# EUROPEAN PATENT APPLICATION

(21) Application number: 86110658.1

(22) Date of filing: 01.08.86

(51) Int. Cl.⁴: **G03F 7/10** , G03F 7/16 ,
C08L 33/24

(30) Priority: 17.10.85 US 788366

(43) Date of publication of application:
29.04.87 Bulletin 87/18

(84) Designated Contracting States:
DE FR GB IT

(71) Applicant: International Business Machines
Corporation
Old Orchard Road
Armonk, N.Y. 10504(US)

(72) Inventor: Brunsvold, William R.
22 Clover Hill Rd
Poughkeepsie New York 12603(US)
Inventor: Crockatt, Dale M.
29 Warren Street
Somers New York 10589(US)
Inventor: Skinner, Michael Patrick
9 Gertrude Place
Wappingers Falls New York 12590(US) ·

(74) Representative: Teufel, Fritz, Dipl.-Phys. et al
IBM Deutschland GmbH. Europäische
Patentdienste Postfach 265
D-8000 München 22(DE)

(54) Film-forming compositions comprising polyglutarimide.

(57) This invention relates to a composition of matter useful for applying polyglutarimide-comprised films to a surface, and to a method of determining what the composition of matter should be to obtain a particular applied dry film thickness, wherein the dry film has a uniform thickness profile. In particular, the present invention enables the spin-casting of films comprised of polyglutarimide to film thicknesses greater than 1 micrometer. Films of thicknesses greater than 1 micrometer have particular use in the microelectronics industry, for applications such as planarizing underlayers, metal lift off layers, and as part of multilayer resist structures where it is desired to obtain a high aspect ratio for the resist structure.

## FILM-FORMING COMPOSITIONS COMPRISING POLYGLUTARIMIDE

This invention relates to a composition of matter useful for applying polyglutarimide-comprised films to a surface, and to a method of determining what the composition of matter should be to obtain a particular applied dry film thickness, wherein the dry film has a uniform thickness profile.

Polyglutarimides or polyglutarimide-comprised polymers, i.e., polymers containing glutarimide units, have been determined to be useful as positive photoresist polymers for use in the microelectronics industry. These polymers are sensitive to both electron beam and deep ultraviolet radiation, have a high glass transition temperature, and demonstrate a high temperature stability. The glutarimide-containing photoresists are capable of very fine spatial resolution, and thus are very suitable for micro circuitry processings, as described in U.S. Patent No. 3,964,908 to Bargon et al.

The glutarimide-containing polymers can be used as a single layer photoresist or to create multilayer resist structures. The multilayer resist structures are frequently used as masks or pattern determining structures in metal deposition processes or in etching processes. In both of these types of processes, especially metal deposition processes, the thermal stability of the multilayer resist structure becomes increasingly important as dimensional control becomes more critical. Thus, the interest in polymers demonstrating improved thermal stability, wherein the glass transition temperature of the resist ranges from about 180°C to about 250°C, as has been observed for various polyglutarimides, has increased.

Bargon et al. disclose that polymers containing a polyglutarimide structural unit are useful as positive photoresists. In particular, dimethylglutarimide unit-containing polymers are recommended as being preferred. However, the dimethylglutarimide-containing polymers are reported to have limited solubility in common nonreacting solvents.

Subsequent to Bargon et al., particular solvents which are useful for dissolving polyglutarimide-containing polymers have been described in the literature. These solvents include amide polar aprotic solvents such as dimethylformamide, dimethylacetamide, N-methyl pyrrolidinone, and dimethylpropyleneurea; polar aprotic esteric solvents such as cellosolve acetate; hydroxylic polar protic solvents such as tetrahydrofurfuryl alcohol, acetol, methyl carbitol, and 2-methoxy ethanol; polar aprotic ketonic solvents such as cyclopentanone; small chain polar carboxylic acids such as acetic acid and formic acid; polar ethers such as n-methyl morpholine, n-ethyl morpholine, and tetrahydrofuran; and mixtures of the above.

The literature also points out that compounds which are not solvents for the polyglutarimides can be combined with solvents of the type listed above in order to form a solvent system from which the polyglutarimides can be applied as a film upon a surface. Examples of these compounds include 1-methoxy-2-propanol, cyclohexanone, chlorobenzene, a mixture of cellosolve acetate/xylene/butyl acetate (combination S), xylene, toluene, butyl acetate, 1,2-dimethoxyethane, ethylene glycol mono methyl ether, and 2-4-pentanedione. Recommended combinations from the above listing include dimethylformamide/combination S/chlorobenzene; tetrahydrofurfuryl alcohol/combination S; cyclopentanone; tetrahydrofurfuryl alcohol/methyl acetoacetate; and chlorobenzene/2-methoxy ethanol.

It is useful to add a dye to the photoresist comprising a glutarimide-containing polymer in a solvent system, when the photoresist is to be used as a planarizing underlayer and it is desired to reduce reflectivity during the exposure of the overlaying imaging photoresist layer. Use of dyes in a layer between the substrate and the top layer, wherein the dye is preferably selected to absorb light of the wavelengths used to expose the top layer but does not interfere with processing of underlaying layers, is described in U.S. Patent 4,362,809 to Chen et al.

Currently, there is a developmental photoresist solution which is commercially available and which comprises a polyglutarimide in a combination of methyl carbitol (a hydroxylic, polar protic solvent)/cyclopentanone (a polar, aprotic ketonic solvent). This polyglutarimide-solvent system is acceptable for producing thin, one micrometer thick films useful for some microelectronic applications. However, in cases wherein the topography of the substrate requires the use of either a thick photoresist, greater than one micrometer in thickness, or a multilayer resist wherein a thick planarizing photoresist layer is utilized beneath an overlaying imaging photoresist, the commercially available developmental formulation of polyglutarimide described above photoresist is inadequate. Attempts to generate a two micrometer thick film by spin coating from the commercially available polyglutarimide-containing photoresist resulted in the formation of polymer fibers known as "cobwebbing". The polymer fibers formed during cobwebbing tend to break off and contaminate areas within the microelectronic matrix being processed, thus reducing product yield. In order to meet increasing industry needs for even smaller dimensions, it is necessary to provide photoresist formulations from which films of thicknesses greater than one micrometer can be generated. These formulations for photoresist solutions should provide for long shelf life, nontoxicity, and uniformity of the dry photoresist film, as well as improved utility under the manufacturing conditions used in the production of microelectronics.

These needs are met by the invention as claimed.

In accordance with the present invention, photoresist formulations comprising a polyglutarimide have been developed which permit the generation of film thicknesses greater than one micrometer. The preferred method of film application is spin coating, the requirements for which are described in detail herein. However, the desirable viscosity and evaporation rate characteristics of the formulations of the present invention render them useful for application of films by spray coating and dip coating as well.

The critical characteristics of the formulation are viscosity at film generation temperature and the evaporation rates of the solvents from the solution of polyglutarimide-containing photoresist at film generation temperature. Typically, films are generated upon a substrate by spin coating which is carried out over a temperature range from about 20°C to about 30°C. The spin coating tool and conditions are important. Determination of optimal operating conditions for a spinning tool, given a particular photoresist composition and a desired dry resist film thickness, can be accomplished with minimal experimentation. Optimization of a particular photoresist composition for use on a particular spinning tool can also be accomplished with minimal experimentation, so long as the critical variables are controlled within the recommended ranges disclosed in the present invention. In any event, it is necessary to be able to control the mechanics of spinning, so that a uniform rate of spinning as well as the desired actual rate of spinning, in revolutions per minute, can be obtained. It is also useful to have a tool designed to reduce splash-back during spinning.

Given currently available spin-casting tools, the composition of matter of polyglutarimide-comprised film casting formulations must meet specific limitations or requirements. In particular, in order to obtain dry cast films of thicknesses greater than one micrometer, specialized formulations must be developed. The required viscosity of the polyglutarimide-containing photoresist solution at the time it is initially placed on the substrate surface depends on the desired thickness of the dry film to be applied. For example, at a spin speed of about 3,000 rpm, maintained for a time period of about 30 seconds, in order to obtain a 1.5 micrometer thick coating of polydimethylglutarimide, the preferred viscosity is about 350 centistokes at about 25°C; in order to obtain a 2.5 micrometer thick coating, the preferred viscosity is about 950 centistokes at about 25°C. The upper limit on viscosity of the formulation is dependent upon process factors in preparation of the photoresist formulation, such as pumping and filtering capability; however, in terms of a working film-casting formulation, it has been discovered that the viscosity of the formulation should range from about 390 centistokes to about 1,200 centistokes. Although it might be possible to cast a uniform film using a higher viscosity solution, such higher viscosity solutions are difficult to prepare due to the difficulty of filtration which is used to remove contaminant. The preferred viscosity for producing films about 2 micrometers in thickness ranges from about 500 centistokes to about 600 centistokes. The preferred viscosity range would be at increased viscosity for spin-casting of thicker films. Note that all centistoke measurements are at 25°C.

As important as the above viscosity range, is the rate of the carrier solvent system evaporation over the temperature range at which the spin coating is carried out. The present invention utilizes a carrier solvent system comprised of a mixture of organic compounds including both at least one solvent and at least one non-solvent for the polyglutarimide. This mixture of solvents is used in order to provide a particular set of physical-chemical properties. The example formulations described herein are those which perform best on today's commercially available spinning equipment; however, the concept of the present invention, in terms of control of critical parameters within certain ranges, can be used to develop a suitable polyglutarimide-comprised formulation for new spinning equipment or for dip or spray coating equipment.

When a mixture of solvents is used, typically, unless an azeotrope is formed, the more volatile solvent within the mixture evaporates the most rapidly, so that it exerts the controlling effect on the change in viscosity of the photoresist solution. Using today's spinning equipment in the practice of the present invention, the desired calculated evaporation rate for the major more volatile organic compound in the mixture ranges from about 4 to about 70, when the mixture is used over the 20°C to 30°C temperature range. The preferred calculated evaporation rate under these conditions ranges from about 9 to about 23. The calculated evaporation rate for the major less volatile organic compound in the mixture ranges from about 0.1 to about 8, when used over the 20°C to 30°C temperature range, with a preferred evaporation rate from about 0.8 to about 3.5. All calculated evaporation rates presented herein are relative evaporation rates based on a standard of n-butyl acetate, which is calculated to have an evaporation rate of 100.

The relative evaporation rate calculation is directly related to the Antoine equation, and the method of calculation as well as calculated relative evaporation rates for over 650 solvents have been published under the title of "TABLES OF SOLUBILITY PARAMETERS", by K.L. Hoy, B.A. Price and R.A. Martin of Union Carbide Corporation, Chemicals and Plastics Research and Development Department, South Charleston, W. VA. (May 31, 1967).

In order to obtain a "dry" film, the solids content of the photoresist solution is typically increased to about at least 95% solids by weight. This increase in solids content during the formation of a "dry" film necessitates a drastic viscosity increase. If the increase in viscosity is too rapid, "cobwebbing" occurs. The fibers formed during cobwebbing create a contamination problem and reduce yield on the production line. If the evaporation rate of the solvent system is too slow, the photoresist solution pulls away from the edges of the substrate to which it is being applied, i.e. dewetting occurs.

To obtain the desired initial solution viscosity and an evaporation rate which permits formation of a film of the desired thickness without cobwebbing or dewetting, it is necessary to begin with at least one moderately good to good solvent for the polyglutarimide-containing polymer. Examples of preferred solvents include aprotic amides such as 1-methyl-2-pyrrolidone (NMP), . 1-benzyl-2-pyrrolidone, 1-ethyl-2-pyrrolidone, and 1-cyclohexyl-2-pyrrolidone, 1-acetyl-4-piperidone, 1-methyl piperidone, 1-acetylpiperidine, and 1-methyl-azepin-2-one. Other solvents which can be used include aprotic cyclic esters such as gamma butyrolactone and non-epoxide-forming ethers such as diglyme. Some of the good solvents for polyglutarimide-containing polymers such as dimethylformamide, dimethylacetamide, and chlorobenzene are not as useful because they have been shown to be toxic; in particular, dimethylformamide has been shown to be an embryotoxin.

To this first moderately good to good solvent is added at least one organic compound which alone is a non-solvent for the polyglutarimide-comprised polymer. It has been discovered that when the non-solvent is selected from particular groups of non-solvents, the viscosity of the solvent-non-solvent solution of a polyglutarimide or polyglutarimide-comprising polymer increases. This increase in viscosity is unexpected, since typically upon increasing the proportion of nonsolvent to solvent at a given solids level, the viscosity of the polymeric solution decreases. The most preferred non-solvents for use in the present invention are non-reactive with any of the other ingredients in the photoresist formulation, contain no halogen which causes equipment corrosion problems and problems within the microelectronic matrix, and exhibit minimal toxicity. These preferred nonsolvents are selected from the group consisting of ketones, esters, ethers (with the exception of peroxide forming ethers, which reduce shelf life) and aromatic hydrocarbons. Alcohols can also be used as the non-solvent, but there is a reduction in shelf life which accompanies their use. Preferred alcohols have low affinity for water, are sterically hindered, and have a high pK (greater than about 15).

Notably excluded are acids, amines, anhydrides, aldehydes and self polymerizable solvents such as styrene, the use of any of which results in a very significant decreased shelf life of the photoresist solution.

Additionally, it is preferred to use at least one major non-solvent which exhibits a faster evaporation rate than the major solvent, which enables casting of a thicker film from a solution of a given initial viscosity. The limitation in formulating for a faster evaporating major non-solvent can easily be determined, since use of a non-solvent with too high an evaporation rate will result in film non-uniformity. As previously stated, the desired evaporation rate for the more volatile organic compound ranges from about 4 to about 70; it is preferred to have this be the evaporation rate for the major non-solvent.

Non-solvents among the preferred groups, which meet the evaporation rate requirements above, include ketones such as hexyl methyl ketone, diisobutyl ketone, cyclohexanone, methyl amyl ketone, dipropyl ketone, methyl isoamyl ketone, ethyl butyl ketone, 2,4-pentanedione, 5-ethyl-3-hepten-2-one, and 2,5-hexanedione; esters such as 2,5-endomethyl-enecyclohexyl acetate, 2,2,4-trimethyl-3-pentyl acetate, 2,6-dimethyl-4-heptyl acetate, 2,5-endomethylene-3-cyclohexenyl acetate, isopropyl acetoacetate, 2,2,4-trimethylpentyl acetate, ethyl acetoacetate, ethyl-3-ethoxybutyrate, methyl-acetoacetate, 2-heptyl acetate, 4-methyl-2-pentyl butyrate, 3-methoxybutyl acetate, 3-heptyl acetate, butyl butyrate, hexyl acetate, ethyl-3-ethoxypropionate, 2-ethylbutyl acetate, 3,3-dimethylbutyl acetate, and 4-methyl-2-pentyl acetate; non-epoxide-forming ethers such as diethyl carbitol, vinyl 2-ethylhexyl ether, 2-formyl-3,4-dihydro-2h-pyran, 2-ethoxy-3, 4-dihydro-1,2-pyran, methoxypropylacetate, methoxybenzene, 1,1,3-trimethoxybutane, 1,1-diethoxybutane and butyl ether; and aromatic hydrocarbons such as t-butylbenzene, isobutylbenzene, o-ethyltoluene, m-ethyltoluene, p-ethyltoluene, isopropylbenzene, o-xylene, m-xylene, and p-xylene. The above list is not all inclusive, but provides a good sampling of the kinds of preferred non-solvents for use in the present invention.

Thus, the use of a specially selected non-solvent in combination with the good solvent for the polyglutarimide or polyglutarimide-containing polymer provides simultaneously a higher solution viscosity, enabling the formation of "dry" photoresist films of thicknesses greater than one micrometer, and a method of controlling the rate of viscosity increase during the spin coating process, so as to avoid both cobwebbing and dewetting. The key to viscosity control during spin coating is the proper balance between solvent and nonsolvent, so that the desired balance is achieved between the viscosity increase due to increased solids and the viscosity decrease attributable to the more rapid evaporation of the more volatile non-solvent.

A balance of these two competing factors permits a more controlled rate of viscosity increase during the spin casting operation. Since too high a viscosity results in cobwebbing and too low a viscosity results in a thinner than desired dry cast film, it is possible to use the above combination of solvents and non-solvents to cast the film over an optimum viscosity range, to achieve a desired film thickness. In particular, use of the above discovery permits the formation of thicker films under a given set of spin-coating conditions, using a formulation comprising a glutarimide or glutarimide-containing polymer.

Films ranging from less than one micrometer to about 2.5 micrometers in thickness have been spin-cast without the formation of cobwebbing, when a film-casting formulation comprised of a polyglutarimide and a combination of the solvents and non-solvents described above was used. It is believed that even thicker films can be formed using the concept of the present invention.

If the ratio of major solvent to major non-solvent is too large, a higher polymer solids loading is required in order to obtain a given film thickness. In addition, if the ratio of solvent to non-solvent is too large, the overall solvent evaporation rate is too low and a form of resist dewetting often referred to as edge pullback can occur. If the ratio of major solvent to major non-solvent is too small, the viscosity of the solution increases to a range wherein filtration becomes impractical; in addition, cobwebbing and striations within the cast film begin to occur. At a sufficiently small ratio of solvent to non-solvent, precipitation of the glutarimide-comprised polymer may occur. Thus, there are limitations on the ratio range over which the specially selected combination of solvents and non-solvents can be used. It is possible to add surfactants to aid in the formation of a more uniform film thickness; however, surfactants are recommended more for fine tuning of an already promising formulation, if they are used at all.

The preferred solvent is selected from the group consisting of the aprotic amides listed previously, and the preferred non-solvent is selected from the group consisting of the ketones, esters and non-epoxide-forming ethers listed above. The acceptable ratio of solvent:non-solvent, wherein the solvent and non-solvent are selected from the groups listed above, ranges from about 1:19 to about 2:1, solvent:non-solvent. When the polyglutarimide-comprised polymer is polydimethylglutarimide, the preferred ratio of solvent to non-solvent in the film-casting formulation ranges from about 1:4 to about 3:7, and the preferred combined concentration of solvent and non-solvent in the formulation ranges from about 80% by weight to about 95% by weight of the solution. For polydimethyl-glutarimide polymer having a weight average molecular weight ranging from about 60,000 to about 100,000 (as measured by GPC in a THF solvent, using a polystyrene standard), the preferred ratio of solvent to non-solvent ranges from about 1:4 to about 3:7, and the preferred combined concentration of solvent and non-solvent in the formulation ranges from about 84% by weight to about 86% by weight.

As the molecular weight and/or structure of the polyglutarimide polymer are varied, it may be necessary to adjust the combined concentration of solvent and non-solvent in the formulation, so that the desired viscosity range is maintained. However, if the film thickness obtained is less than required, even at viscosities as high as 1,200 centistokes, it may be necessary to use a different combination of solvent and non-solvent which provides a viscosity within the acceptable range at a combined concentration of solvent and non-solvent ranging between about 80% by weight and about 95% by weight of the solution.

For applications in which the polyglutarimide film-forming formulation is to be used as the underlaying photoresist layer in a multilayer photoresist process, it is useful to add a dye to the underlaying photoresist formulation, to reduce reflectivity during the exposure of the overlaying layer. It has been discovered that good adhesion of the polyglutarimide-comprised underlaying photoresist layer to a typical substrate used in the microelectronics industry requires a bake at a temperature above the polyglutarimide-comprised polymer's glass transition temperature. As previously described, the glass transition temperature for polymers of the type used in the formulation of the present invention ranges from about 180°C to about 250°C. However, it has been discovered that use of bake temperatures above 180°C results in the sublimation of dyes like coumarin 6, coumarin 7, and coumarin 30, which have been recommended for use in underlaying resist layers in the literature. These dyes, by themselves, would not sublime at temperatures as high as 250°C; apparently when the dye is dispersed in the glutarimide-comprised polymer, the crystalline energy of the dye is overcome, so that the normal stabilizing effect of the dye crystalline energy is not functional. The sublimation problem can be minimized using at least one of three methods: 1) an increase in weight average molecular weight of the dye, 2) use of an ionic species dye, and 3) binding the dye to the glutarimide-comprising polymer. The ionic species dyes are biologically active molecules and are soluble in water, providing increased bio hazard, so there are process disadvantages in using them. When the dye is bound directly to the glutarimide comprised polymer, the effect on the photocharacteristics of the polymer is difficult to control and the result is limitation to a particular wavelength sensitivity. Thus, the preferred method of reducing sublimation of the dye is to use dyes with increased molecular weight and having the desired wavelength sensitivity. The dye should have a sufficiently high molecular weight to reduce volatility and provide adequate thermal stability during processing of the microelectronic device. It has been discovered that dyes having a molecular weight of at least 340, the required wavelength sensitivity, and which are soluble in the formulation at the desired concentration, perform well when polydimethyl-glutarimide polymer is used in the formulation. For polyglutarimide-comprised polymers having glass transition temperatures ranging from about 180°C to about 250°C, a dye having a molecular weight which ranges from about 400 to about 510 is preferred.

In addition, it is helpful to use a dye which exhibits a high extinction coefficient in the desired range of exposure of the overlaying layer while exhibiting low absorbtivity in the wavelength at which the underlaying photoresist of the present invention is exposed, to provide maximum sensitivity in this underlaying layer. Polyglutarimide comprised polymers are sensitive to wavelengths ranging from about 230 to about 270 nm, thus the dye selected should have low absorbtivity at this wavelength. When ultraviolet light is used to expose the overlaying layer of photoresist in the present invention, diazo derivative dyes and coumarin dyes meeting the molecular weight requirements, having high extinction coefficients at 313nm, 365nm, 406nm, and/or 436nm radiation wavelengths, and having low adsorptivity between about 230 to about 270 nm, are particularly effective within the formulations of the present invention. Examples of such dyes include, but are not limited to, 4-((1-butyl-5-cyano-1,6-dihydro-2-hydroxy-4-methyl-6-oxo-3-pyridinyl)azo)-N-(2-ethyl-hexyl)-benzene-sulfonamide, which is commercially available as Zapon Yellow 073 or BASF solvent yellow 162, and 3,3'-carbonylbis (7-diethylaminocoumarin).

FIG. 1 is a contour graph showing the solution viscosity in centistokes of a photoresist formulation comprised of PMGI, NMP, and cyclohexanone, as a function of the concentration of these three components.

FIG. 2 is a contour graph showing the dry film thickness in micrometers of a film spin-cast from a photoresist formulation comprised of PMGI, NMP, and cyclohexanone, as a function of the concentration of these three components.

FIG. 3 is a film thickness profile for a dry film of photoresist spin-cast on a silicon wafer. The area shown in the profile is the center 3.5-inch diameter portion of a 5-inch diameter silicon wafer with the film cast on it. The photoresist formulation used to cast the film profiled was comprised of polydimethylglutarimide polymer (PMGI), N-methyl pyrrolidione (NMP) solvent, and anisole non-solvent.

FIG. 4 is a dry film thickness profile, as described for FIG. 3, wherein the photoresist formulation used to cast the film profiled was comprised of PMGI, NMP solvent, and methyl crotonate non-solvent.

FIGS. 5A and 5B are dry film thickness profiles, as described above, wherein the photoresist formulation used to cast the film profiled was comprised of PMGI, NMP solvent, and methylacetoacetate non-solvent. FIG. 5A is the film profile for a photoresist formulation wherein the initial % by weight PMGI was 15%. FIG. 5B is the film thickness profile for a photoresist formulation wherein the initial % by weight PMGI was 16%.

FIG. 6 is a graph for a dye-containing photoresist, showing the percent absorbance (due to presence of the dye) remaining as the temperature of a cast film of the photoresist is increased. The plot shows data for three dyes recommended in the literature for use in underlaying layers of multilayer photoresist structures.

FIGS. 7, 8, and 9 are graphs for dye-containing photoresists, showing the decrease in percent absorbance remaining after a 60 minute, 200°C bake of a film of the photoresist as cast on a quartz substrate. All films are comprised of the same photoresist polymer. FIG. 7 is the graph for a film containing coumarin 7 dye. FIG. 8 is the graph for a film containing coumarin 30 dye. FIG. 9 is the graph for a film containing 3.3'-carbonylbis-7-diethylamino-coumarin dye.

FIG. 10 is a graph showing the decrease in percent absorbance remaining after a 60 minute, 200°C bake of a film of PMGI photoresist containing 3,3′-carbonylbis-7-diethylamino coumarin dye, wherein the photoresist was spin-cast on a quartz wafer substrate.

FIG. 11 is a graph showing the decrease in percent absorbance remaining after a 60 minute, 200°C bake of a film of PMGI photoresist containing BASF Solvent Yellow 162 dye, wherein the photoresist was spin-cast on a quartz wafer substrate.

FIG. 12 is a dry film thickness profile of the type previously described, wherein the photoresist is a dye-containing photoresist.

FIG. 13A and 13B are photomicrographs showing multilayer resist structures, wherein the lower, underlaying layer of resist is a dye-containing PMGI photoresist. The dye-containing PMGI photoresist was spin-cast on a silicon wafer substrate from a photoresist solution meeting the requirements of the present invention.

The present invention has been reduced to practice in the form of numerous embodiments, several of which are described below.

EXAMPLE 1

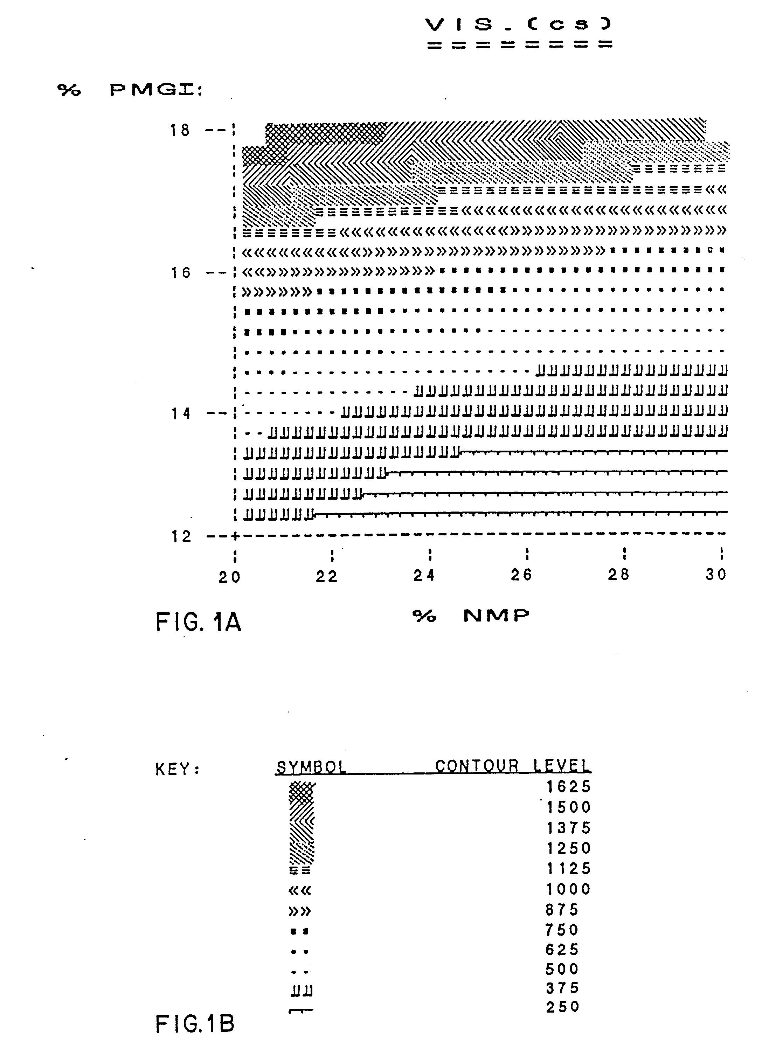

The discovery that the solution viscosity of a polyglutarimide-comprised photoresist could be increased by increasing the proportion of organic component which was a non-solvent for the polyglutarimide polymer was initially demonstrated for a formulation comprised of polydimethylglutarimide (PGMI), N-methyl pyrrolidione (NMP) solvent, and cyclohexanone non-solvent. The contour graph representing the data demonstrating this phenomenon is presented in FIGS. 1A and 1B. FIG.1A shows the solution viscosity in centistokes as a function of the concentrations of PMGI, NMP, and cyclohexanone. The sum of the three components is 100%. The cyclohexanone component concentration can be calculated by the formulation:

% cyclohexanone = 100 -(% PMGI + % NMP)

At a given concentration of PMGI polymer, ranging between 12 and 18 % by weight of the solution, the viscosity of the solution of the polymer increases as the relative amount of the cyclohexanone component increases. Cyclohexanone is a non-solvent for PMGI, while NMP is known to be a good solvent for PMGI. FIG. 1B is the key to permit interpretation of the viscosity perameter of FIG. 1A.

EXAMPLE 2

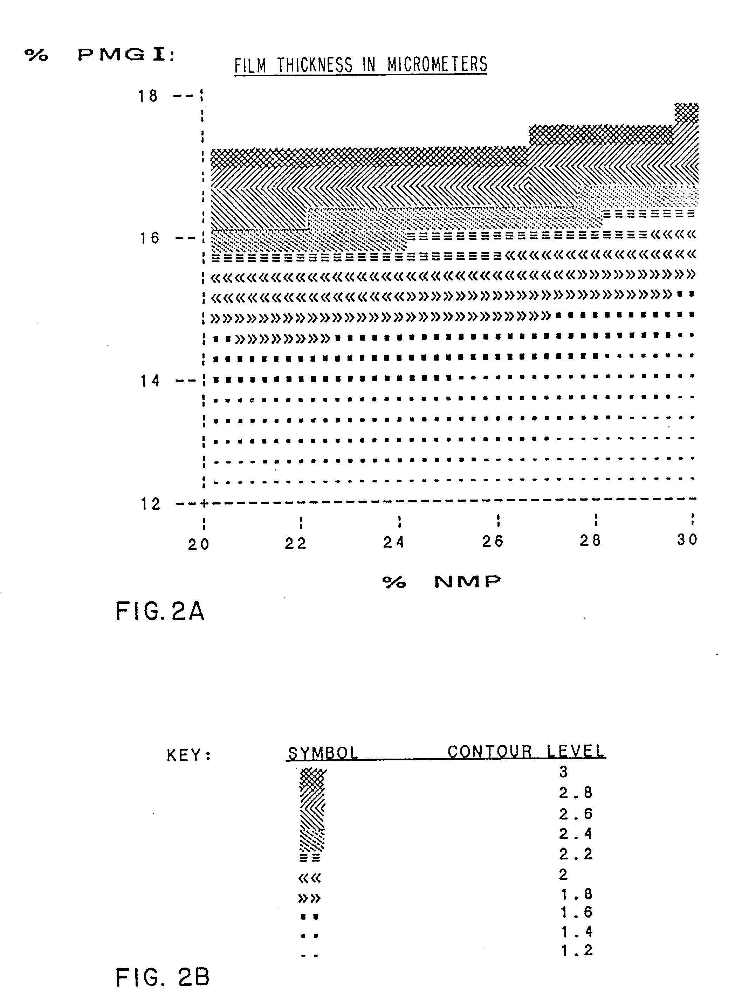

The ability to obtain increased film thickness of polyglutarimide-comprised spin-cast films, holding all variables constant except the ratio of solvent concentration to nonsolvent concentration, was initially demonstrated for the same PMGI/NMP/cyclohexanone formulation as that given in EXAMPLE 1. The contour graph representing data demonstrating this principle is shown in FIGS. 2A and 2B. FIG. 2A represents dry film thickness data for films cast from the NMP/cyclo hexanone mixed solvent system solutions described in FIGS.1A and 1B. At a given initial concentration of PMGI polymer, ranging between 12% and 18 % by weight of the solution, the thickness of a film spin-cast from the PMGI solution increases as the relative amount of the cyclohexanone component increases. This increase in film thickness is believed to be due, in part, to the increase in initial viscosity of the PMGI solution with the increase in the relative amount of the cyclohexanone component. This increase in film thickness is also believed to be due, in part, to the faster evaporation rate of the cyclohexanone component (22.4) compared to the evaporation rate of the NMP component (less than 2). FIG. 2B is the key to permit interpretation of the film thickness parameter of FIG. 2A.

EXAMPLE 3

As previously stated, using the concept of the present invention, an optimized composition of the film-forming photoresist solution for use on particular spin-casting equipment can be determined with minimal experimentation. For example, two formulations comprising NMP as the solvent, anisole as the non-solvent, and PMGI as the polyglutarimide were prepared. The composition of formulation 1 was: 21.37% by weight NMP, 64.11% anisole, and 14.5% PMGI. The viscosity of this solution was 518 centistokes, (within the recommended viscosity range of 390 to 1,200 centistokes). The combined concentration of solvent and nonsolvent was 85.5 % (within the recommended range when PMGI is used as the polyglutarimide). The ratio of solvent:non-solvent was 1:3 (within the recommended range). The evaporation rate for the more volatile non-solvent, anisole was 35.5 (within the recommended range). This formulation was spin-cast on a (12,7 cm) 5-inch diameter silicon wafer substrate, using commercially available equipment operated at a spin speed of 3,000 rpm for a time period of about 60 seconds. The resultant film thickness was 1.87 micrometers.

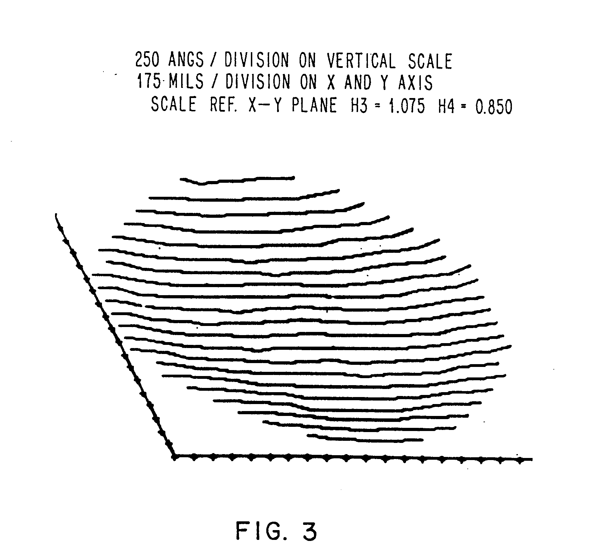

Since the desired film thickness was 2.0 micrometers, the formulation was modified to obtain the desired thickness. The composition of Formulation 2 was: 21.25% NMP, 63.75% anisole, and 15% PMGI. The viscosity of this solution was 594 centistokes (within the recommended range). The combined concentration of solvent and non-solvent was 85% (within the recommended range when PMGI of about 80,000 molecular weight is used as the polyglutarimide). The ratio of solvent:non-solvent was 1:3 (within the recommended range). As previously pointed out, the evaporation rate of anisole is within the recommended range. This formulation was spin-cast on a silicon wafer substrate under the same conditions as was Formulation 1. The resultant film thickness was 2.11 micrometers, with a thickness standard deviation of 4,8 nm (48 Å) over a 8,89 cm (3.5-inch) diameter center section of the wafer. The film thickness profile for this 3.5-inch diameter area is shown in FIG. 3. The FIG. 3 "z" (film thickness) scale is 2,5 nm (250 Å) per division, and the "x" and "y" scales are 4,45 mm - (175 mils or .175 inches) per division. Measurement of the dry film thickness profile was done using an IBM Film Thickness Analyzer Model 7840. Thus, it is possible to make minor adjustments within the recommended composition parameters in order to optimize the formulation for a given piece of spin-casting equipment.

EXAMPLE 4

Two formulations comprising PMGI polymer, a preferred solvent of NMP, and a non-solvent with an evaporation rate below the recommended evaporation rate of 4 were prepared. The non-solvent was methyl benzoate, which has an evaporation rate of 3.31. Formulation 1 comprised: 21.25% by weight NMP, 63.75% by weight methyl benzoate, and 15% by weight PMGI. The viscosity of this solution was 838 centistokes (within the recommended range). The combined solvent concentration was 85% (within the recommended range when PMGI of about 80,000 molecular weight is used as the polyglutarimide). The ratio of solvent:non-solvent was 1:3 (within the recommended range). The formulation was spin-cast upon the surface of a silicon wafer using spinning conditions the same as those described for the previous examples. The dry film thickness obtained was about 1.6 micrometers. Dewetting, in the form of edge pull-back, was observed. The dewetting was attributed to too low an evaporation rate for the methyl benzoate non-solvent. Formulation 2 comprised: 21.125% NMP, 63.375% methyl benzoate and 15.5% PMGI. The viscosity of this solution was 1,185 centistokes, which made it diffucult to filter for removal of contaminates. However, this increase in viscosity did make it possible to obtain a 1.9 micrometer thick dry film, whereas the previous formulation produced only a 1.6 micrometer thick dry film. Again, edge pullback was observed.

EXAMPLE 5

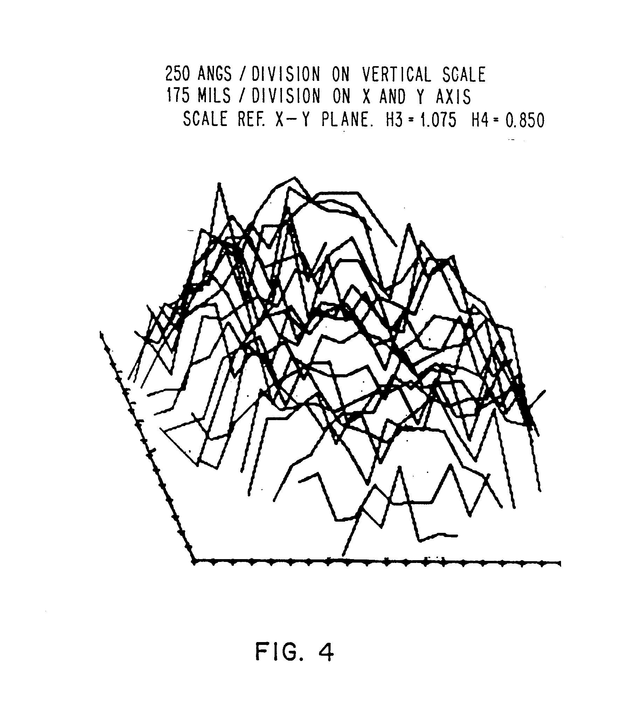

Two formulations comprising PMGI polymer, a preferred solvent of NMP, and a non-solvent with an evaporation rate above the recommended evaporation rate of 70 were prepared. The non-solvent was methyl crotonate which has an evaporation rate greater than 76. Formulation 1 comprised: 21.375% by weight NMP, 64.125% by weight methyl crotonate, and 14.5% by weight PMGI. The viscosity of this solution was 257 centistokes (less than the recommended viscosity range). The combined solvent concentration was 85.5 % (within the recommended range when PMGI of about 80,000 molecular weight is used as the polyglutar-imide). The ratio of solvent:non-solvent was 1:3 (within the recommended range). This formulation was spin-cast on a silicon wafer substrate under the same spinning conditions as previously described. The dry film thickness obtained was difficult to measure due to severe non-uniformity of the cast film. Both cobwebs and nubs were observed on the film surface. FIG. 4 shows the dry film thickness profile for this spin-cast film. The profile is for an area of about 3.5 inches in diameter in the center of the wafer. The "z" (film thickness) scale is 25 nm (250 Å) per division. The "x" and "y" scales are 4,45 mm (175 mils or .175 inch) per division. The non-uniformity was so severe that a standard deviation could not be measured. The cobwebs, nubs, and the high degree of non-uniformity were attributed to too high an evaporation rate of the non-solvent. However, since the viscosity of the solution was less than the recommended range, a second formulation was prepared with a viscosity within the recommended range.

Formulation 2 comprised: 21.25% by weight NMP, 63.75% by weight methyl crotonate, and 15% by weight PMGI. The viscosity of this solution; was 328 centistokes (within the recommended viscosity range). The combined solvent concentration was 85% (within the recommended range when PMGI of about 80,000 molecular weight is used as the polyglutarimide). The ratio of solvent:non-solvent was 1:3 (within the recommended range). The formulation was spin-cast on a silicon wafer substrate as previously described. The dry film thickness obtained was 2.51 micrometers, with a standard deviation of 94,3 nm (943 Å). Again, there were cobwebs and nubs, and film non-uniformity, as is evidenced by the large standard deviation (greater than the standard deviation of 20 nm (200 Å), which is considered good). Again, the cobwebs, nubs, and film non-uniformity were attributed to too high an evaporation rate of the non-solvent.

## EXAMPLE 6

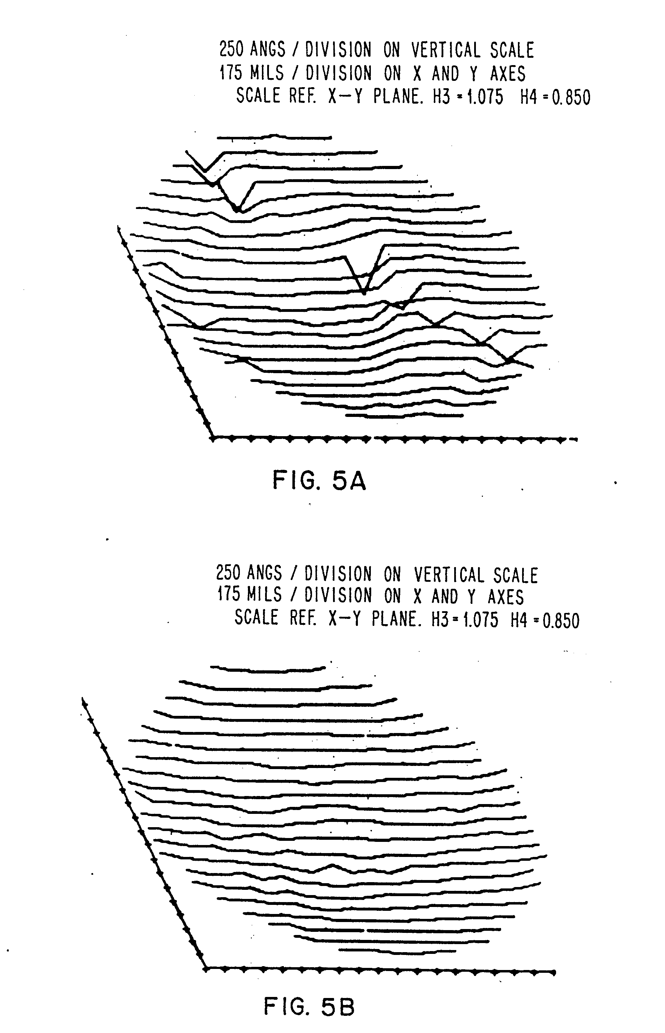

Another embodiment of the present invention is a formulation comprising PMGI polymer, NMP solvent, and methylacetoacetate as the non-solvent. The evaporation rate for methylacetoacetate is 9.8, compared with the 3.3 evaporation rate of the methyl benzoate of EXAMPLE 4, the 35.5 evaporation rate of the anisole of EXAMPLE 3, and with the 76 evaporation rate of the methyl crotonate of EXAMPLE 5. Two formulations were prepared using methylacetoacetate non-solvent, and evaluated order to show the performance characteristics of this non-solvent, as well as the effect resulting from an increase in the PMGI polymer solids concentration with accompanying viscosity increase. Formulation 1 comprised: 21.25% by weight NMP, 63.75% by weight methylacetoacetate, and 15% by weight PMGI. The viscosity of this solution was 371 centistokes. The combined concentration of solvent and nonsolvent was 85%; the ratio of solvent:non-solvent was 1:3; and the evaporation rate for the non-solvent was 9.8 (all parameters within the recommended range). This formulation was spin-cast onto a 5-inch diameter silicon wafer substrate, as previously described. The resultant dry film thickness was 1.52 micrometers, with a standard deviation of 4,6 nm (46 Å). No cobwebbing or nubs were observed on the cast film. The dry film thickness profile for an area of about 3.5 inches in diameter, in the center of the wafer, is shown in FIG. 5A. The "z" (film thickness) scale is 25 nm - (250 Å) per division. The "x" and "y" scales are 4,45 mm (175 mils or .175 inch) per division.

Formulation 2 comprised: 21% by weight NMP, 63% by weight methylacetoacetate, and 16% by weight PMGI. The viscosity of this solution was 558 centistokes. The combined concentration of solvent and nonsolvent was 84%; the ratio of solvent:non-solvent was 1:3; and the evaporation rate for the non-solvent was 9.8 (all parameters within the recommended range). This formulation was spin-cast onto a 5-inch diameter silicon wafer substrate, as previously described. The resultant dry film thickness was 1.90 micrometers, with a standard deviation of 3,5 nm (35 Å). The dry film thickness profile, with the same scale as described earlier in this example, is shown in FIG. 5B.

## EXAMPLE 7

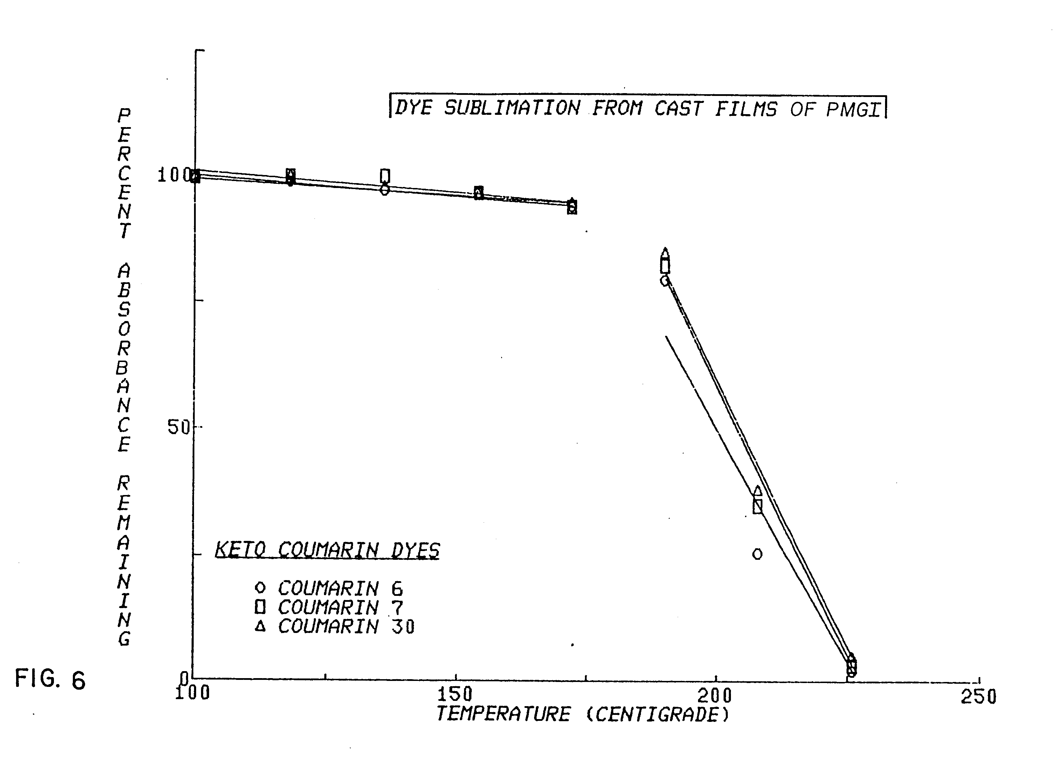

It has been pointed out in this specification that when the photoresist comprised of a polyglutarimide is used as the underlaying layer in a multilayer structure, and it is desired to reduce reflectivity from structures underlaying the polyglutarimide comprised photoresist during exposure of overlaying resist layers to radiation, a dye may be added to the photoresist formulation comprised of a polyglutarimide. Dyes recommended in the literature included coumarin dyes, particularly coumarin 6, coumarin 7, and coumarin 30. As previously discussed, in order to obtain good adhesion of the photoresist comprised of a polyglutarimide to microelectronic substrates such as silicon, it is necessary to take (usually by baking) the temperature of the polyglutarimide coated substrate to at least the glass transition temperature of the polyglutarimide. This glass transition temperature ranges from about 180°C to about 250°C. It has been discovered that when any one of the three coumarin dyes above is placed in a photoresist comprised of PMGI, and the photoresist is heated to temperatures above about 170°C, for a period of about 60 minutes, the effectiveness of the dye begins to decrease as a function of the temperature to which the photoresist is heated. This phenomenon is depicted in FIG.6.

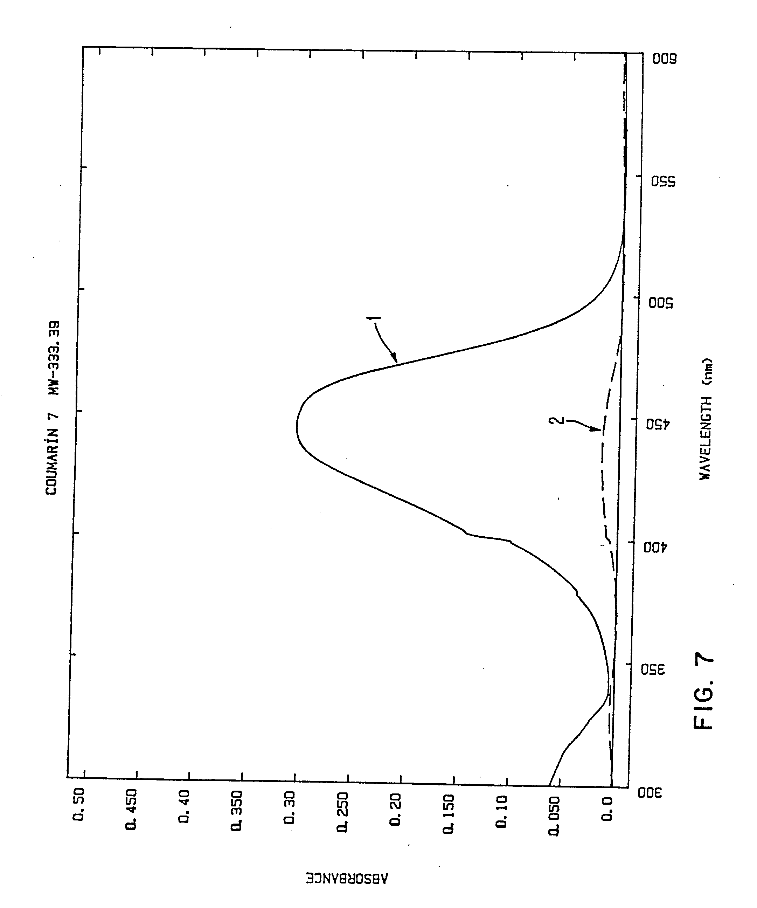

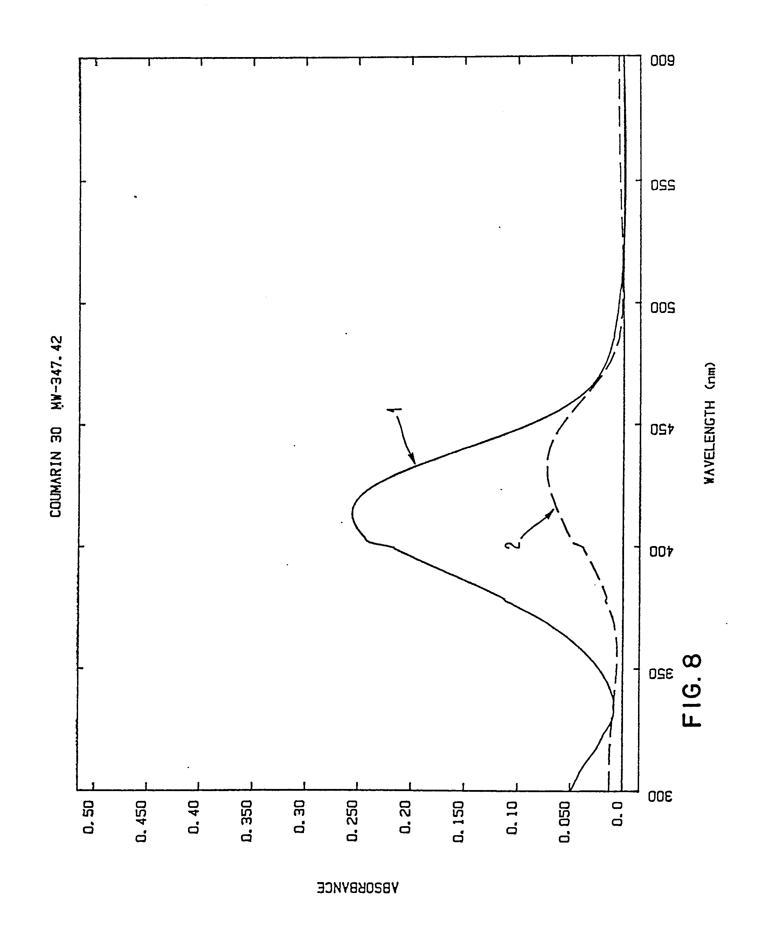

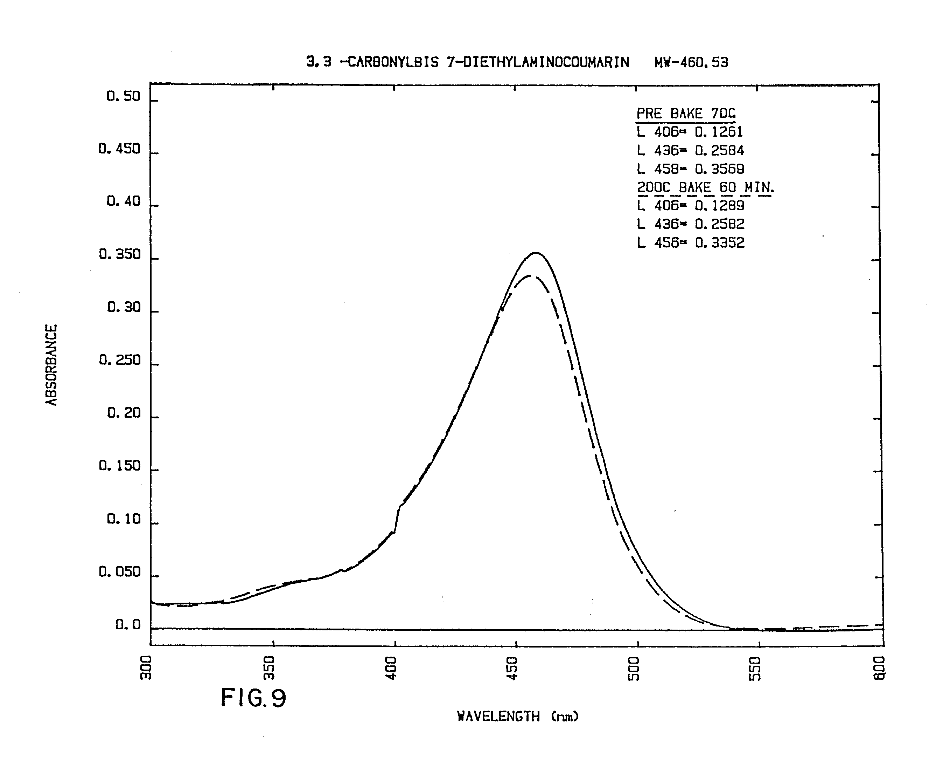

As previously described, it has been discovered that one method, the preferred method, of preventing the loss of effectiveness of the dye is to increase the molecular weight of the dye. FIGS. 7, 8, and 9 show the absorbance, at various wavelengths of radiation, of a photoresist containing a dye, after a prebake at 70°C for a period of about 30 minutes 1, and the absorbance remaining after an additional bake at 200°C for a period of about 60 minutes 2. The photoresist comprises a terpolymer of acrylic derivatives in all the FIGS. The dyes used in combination with the terpolymer increase in molecular weight for FIGS. 7, 8, and 9, respectively. The initial concentration of dye in the photoresist was about 3%, based on the terpolymer and the dye in combination only. Note that coumarin 7 having a molecular weight of about 333, and coumarin 30 having a molecular weight of about 347 show a large reduction in effectiveness after the 200°C bake 2, whereas the 3,3'-carbonyl-bis 7-diethylamioncoumarin having a molecular weight of about 460 remains substantially effective even after the 200°C bake 2.

## EXAMPLE 8

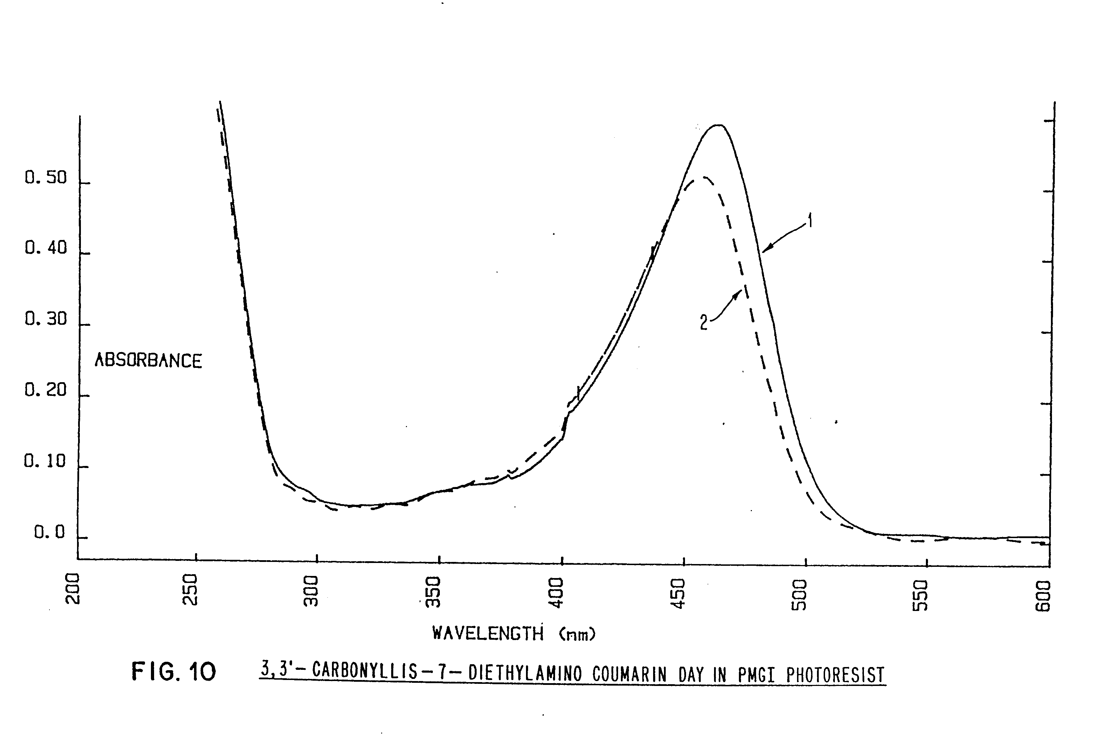

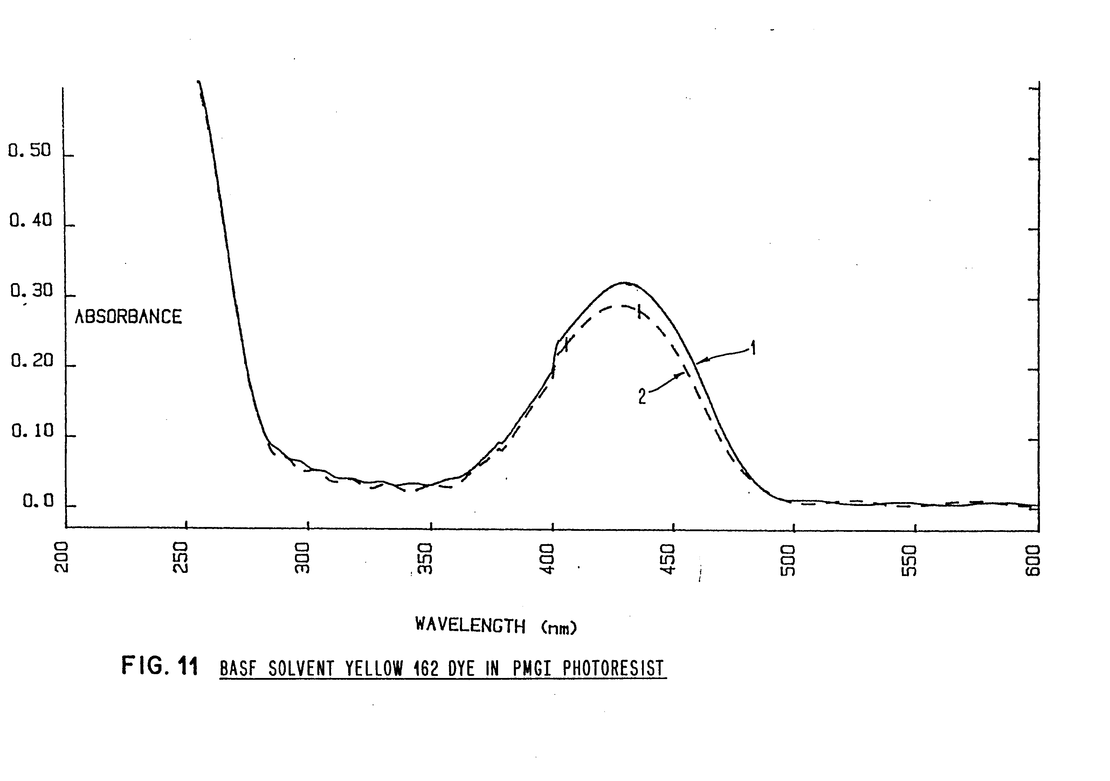

FIGS. 10 and 11 depict the absorbance characteristics of photoresists comprising PMGI polymer and a high molecular weight dye (which has the required absorbtion characteristics previously described), after a 70°C bake 1, for a period of about 30 minutes, and after a 200°C bake 2, for a period of about 60 minutes. The photoresist of FIG.

10 is comprised of PMGI polymer and the 3,3'-carbonylbis-7-diethylamino coumarin dye, wherein the molecular weight of the dye is about 460, and the initial dye concentration was about 3% based on the PMGI polymer and the dye in combination only. The photoresist of FIG. 11 was comprised of PMGI polymer and BASF Solvent Yellow 162 dye, wherein the molecular weight of the dye was about 501 and the initial dye concentration was about 3% based on the PMGI polymer and the dye in combination only. Note that very little of the absorbance attributable to the presence of the dye was lost after the 200°C bake in either case.

EXAMPLE 9

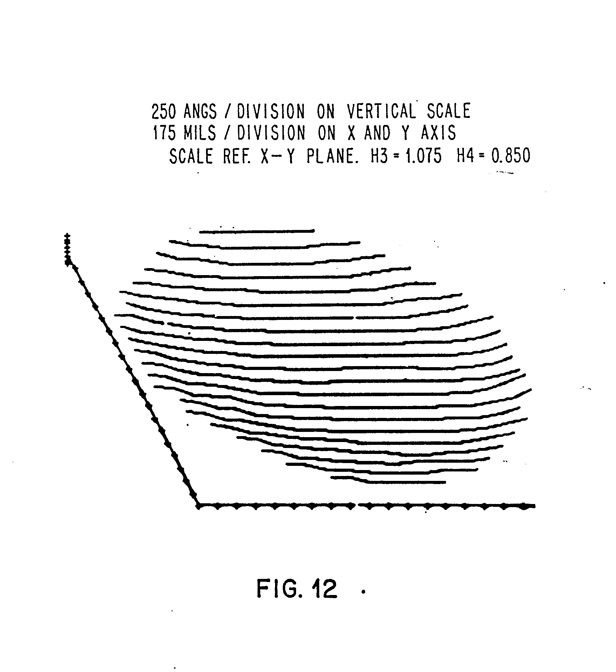

The presence of a high molecular weight dye which is soluble in the photoresist formulation does not affect the ability of the photoresist formulation to form a uniform film thickness coating without cobwebbing or nubs. FIG. 12 shows the dry film thickness profile for a photoresist formulation comprising 0.26% by weight 3,3'-carbonylbis-7-diethylamino coumarin dye, 20.93% by weight NMP, 62.81% by weight cyclohexanone, and 16% by weight PMGI. The viscosity of the photoresist solution was about 500 centistokes. The dry film thickness was 2.08 micrometers with a standard deviation of 5,4 nm (54 Å).

EXAMPLE 10

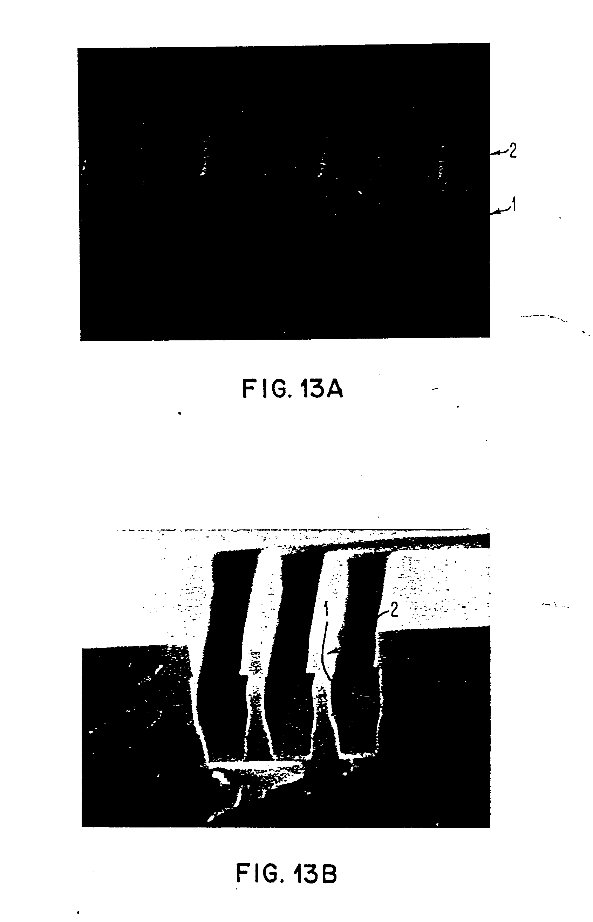

FIGS. 13A and 13B are photomicrographs showing a multilayer resist structure formed using a PMGI photoresist as the lower layer and a commercially available novolak as the upper layer. The photoresist formulation used to spin-cast the lower layer was the formulation given in EXAMPLE 9. In FIG. 13A, the developed image width is about 1.5 micrometers, with the height of the lower PMGI layer being about 2.0 micrometers, and the height of the novolak upper layer being about 1.0 micrometer. In FIG. 13B, the developed image width is about 0.8 micrometers, with the height of the lower PMGI layer being about 2.0 micrometers, and the height of the novolak upper layer being about 1.0 micrometer.

**Claims**

1. A film-forming composition comprising a polyglutarimide in solution, preferably a poly-dimethylglutarimide, wherein said solution compo-

nents, in addition to said polyglutarimide, include at least both a solvent and a nonsolvent for said polyglutarimide.

2. The composition of claim 1, wherein the initial viscosity at film generating temperature between about 20°C to about 30°C ranges from about 390 to about 1,200 centistokes, preferably from about 500 to about 600 centistokes.

3. The composition of claim 1 or 2,

wherein the ratio of the major slower evaporating component to said major faster evaporating component ranges from about 1:19 to about 2:1, respectively, preferably from about 1:4 to about 3:7, respectively.

4. The composition of one of the claims 1 to 3, wherein the evaporation rate of the major faster evaporating component ranges from about 4 to about 70.

5. The composition of one of claims 1 -4, wherein the evaporation rate of the major slower evaporating component ranges from about 0.1 to about 8.0.

6. The composition of one of the claims 1 -5, wherein said non-solvent is said faster evaporating component.

7. The composition of one of the claims 1 -6, wherein said solvent is selected from the group consisting of aprotic amides, aprotic cyclic esters, and non-epoxide-forming ethers.

8. The composition of one of the claims 1 -7, wherein said solvent is selected from the group consisting of 1-methyl-2-pyrrolidone, 1-benzyl-2-pyrrolidone, 1-ethyl-2-pyrrolidone, 1-cyclohexyl-2-pyrrolidone, 1-acetyl-4-piperidone, 1-methylpiperidone, 1-acetylpiperidine, 1-methyl-azepin-2-one, gamma-butyrolactone, and diglyme.

9. The composition of one of the claims 1 -8, wherein said nonsolvent is selected from the group consisting of ketones, esters, non-epoxide-forming ethers, alcohols, and aromatic hydrocarbons.

10. The composition of one of the claims 1 -9, wherein said nonsolvent is selected from the group consisting of hexylmethyl ketone, diisobutyl ketone, cyclohexanone, methylamyl ketone, dipropyl ketone, methylisoamylketone, ethylbutyl ketone, 2,4-pentanedione, 5-ethyl-3-hepten-2-one, 2,3-hesanedione, 2,5-endomethylenecyclohexylacetate, 2,2,4-tirmethyl-3-pentylacetate, 2,6-dimethyl-4-heptylacetate, 2,5,-endomethylene-3-cyclohexenylacetate, isopropylacetoacetate, 2,2,4-trimethylpentylacetate, ethylacetoacetate, ethyl-3-ethoxybutyrate, methyl-acetoacetate, 2-heptylacetate, 4-methyl-2-pentylbutyrate, 3-methoxybutylacetate, 3-heptylacetate, butylbutyrate, hexylacetate, ethyl-3-ethoxypropionate, 2-ethylbutylacetate, 3,3-dimethylbutylacetate, 4-methyl-2-pentylacetate, diethylcarbitol, vinyl-2-ethylhexylether, 2-formyl-3,4-dihydro-2h-pyran, 2-ethoxy-3,4-dihydro-1,2-pyran, methoxypropylacetate, methoxybenzene, 1.1.3-trimethoxybutane, 1.1-diethoxybutane, and butylether.

11. The composition of one of the claims 1 -10, wherein said solution also includes a dye exhibiting a sufficiently low volatility at the glass transition temperature of said polyglutarimide to substantially remain in the dry film cast from said film-forming composition when said dry film is raised to temperatures at least as high as the glass transition temperature of said polyglutarimide, and wherein said dye exhibits sufficient thermal stability that it does not change to a form exhibiting undesirable absorbance characteristics upon exposure to temperatures at least as high as the glass transition temperature of said polyglutarimide.

12. The composition of claim 11, wherein said dye is selected from dyes having a molecular weight greater than about 340.

13. The composition of claim 11 or 12, wherein said dye is selected from the group consisting of coumarin derivative dyes and azo derivative dyes.

14. A method of determining a film-forming composition in accordance with one of the claims 1 -13 comprising the steps of:

a) determining an at least three component mixture which provides an initial single phase solution viscosity ranging from about 390 centistokes to about 1200 centistokes, for said mixture of said polyglutarimide, said at least one solvent for said polyglutarimide, and said at least one non-solvent for said polyglutarimide;

b) determining the film thickness range obtainable for said mixture;

c) determining the ratio of the major of said at least one solvent to the major of said at least one non-solvent at which the desired film thickness uniformity is obtained, wherein said ratio ranges between about 1:19 and about 2:1; and

e) repeating steps a) through c) until the desired film thickness and film thickness unformity is obtained.

15. The method of claim 14, wherein the combined concentration of said at least one solvent and said at least one non-solvent ranges from about 80% by weight to about 95% by weight of said film-forming composition.

V I S . ( c s )
= = = = = = = =

% PMGI:

FIG. 1A

% NMP

KEY:      SYMBOL          CONTOUR LEVEL

| SYMBOL | CONTOUR LEVEL |
|---|---|
|  | 1625 |
|  | 1500 |
|  | 1375 |
|  | 1250 |
| ≡≡ | 1125 |
| «« | 1000 |
| »» | 875 |
| ■ ■ | 750 |
| • • | 625 |
| .. . | 500 |
| ⨆⨆ | 375 |
| — | 250 |

FIG.1B

% PMGI:    FILM THICKNESS IN MICROMETERS

FIG. 2A

% NMP

KEY:    SYMBOL          CONTOUR LEVEL

| SYMBOL | CONTOUR LEVEL |
|---|---|
| | 3 |
| | 2.8 |
| | 2.6 |
| | 2.4 |
| | 2.2 |
| ≪≪ | 2 |
| ≫≫ | 1.8 |
| ▪ ▪ | 1.6 |
| • • | 1.4 |
| - - | 1.2 |

FIG. 2B

250 ANGS / DIVISION ON VERTICAL SCALE
175 MILS / DIVISION ON X AND Y AXIS
SCALE REF. X—Y PLANE  H3 = 1.075  H4 = 0.850

FIG. 3

250 ANGS / DIVISION ON VERTICAL SCALE
175 MILS / DIVISION ON X AND Y AXIS
SCALE REF. X−Y PLANE. H3 = 1.075  H4 = 0.850

FIG. 4

M − FI 985 042

250 ANGS / DIVISION ON VERTICAL SCALE
175 MILS / DIVISION ON X AND Y AXES
SCALE REF. X—Y PLANE. H3 = 1.075 H4 = 0.850

FIG. 5A

250 ANGS / DIVISION ON VERTICAL SCALE
175 MILS / DIVISION ON X AND Y AXES
SCALE REF. X—Y PLANE. H3 = 1.075 H4 = 0.850

FIG. 5B

3M — FI 985 042

0 219 626

DYE SUBLIMATION FROM CAST FILMS OF PMGI

PERCENT ABSORBANCE REMAINING

100

50

0

KETO COUMARIN DYES

o COUMARIN 6
□ COUMARIN 7
△ COUMARIN 30

TEMPERATURE (CENTIGRADE)

100    150    200    250

FIG. 6

COUMARÍN 7   MW-333.39

FIG. 7   WAVELENGTH (nm)

FIG. 8

COUMARIN 30  MW-347.42

0 219 626

3.3 —CARBONYLBIS 7—DIETHYLAMINOCOUMARIN    MW—460.53

PRE BAKE 70C
L 406= 0.1261
L 436= 0.2584
L 458= 0.3569
200C BAKE 60 MIN.
L 406= 0.1289
L 436= 0.2582
L 456= 0.3352

ABSORBANCE

WAVELENGTH (nm)

FIG.9

ABSORBANCE

WAVELENGTH (nm)

3,3'-CARBONYLLIS-7-DIETHYLAMINO COUMARIN DAY IN PMGI PHOTORESIST

FIG. 1O

ABSORBANCE

0.50

0.40

0.30

0.20

0.10

0.0

WAVELENGTH (nm)

200    250    300    350    400    450    500    550    600

1

2

**FIG. 11**   BASF SOLVENT YELLOW 162 DYE IN PMGI PHOTORESIST

250 ANGS / DIVISION ON VERTICAL SCALE
175 MILS / DIVISION ON X AND Y AXIS
SCALE REF. X—Y PLANE. H3 = 1.075  H4 = 0.850

FIG. 12

FIG. 13A

FIG. 13B